# EUROPEAN PATENT SPECIFICATION

(11) **EP 3 862 766 B1**
(45) Date of publication and mention of the grant of the patent: **21.06.2023**
(21) Application number: 21150463.4
(22) Date of filing: 07.01.2021
(51) Int. Cl.: G01R 31/367, G01R 31/3835, G01R 31/392, G06N 3/02

(54) **BATTERY DEGRADATION EVALUATION SYSTEM, BATTERY DEGRADATION EVALUATION METHOD, AND NON-TRANSITORY STORAGE MEDIUM STORING BATTERY DEGRADATION EVALUATION PROGRAM**
BATTERIEVERSCHLEISSBEURTEILUNGSSYSTEM, BATTERIEVERSCHLEISSBEURTEILUNGSVERFAHREN UND NICHTTRANSITORISCHES SPEICHERMEDIUM MIT DARAUF GESPEICHERTEM BATTERIEVERSCHLEISSBEURTEILUNGSPROGRAMM
SYSTÈME D'ÉVALUATION DE DÉGRADATION DE BATTERIE, PROCÉDÉ D'ÉVALUATION DE DÉGRADATION DE BATTERIE, ET SUPPORT DE STOCKAGE NON TRANSITOIRE STOCKANT UN PROGRAMME D'ÉVALUATION DE DÉGRADATION DE BATTERIE

(30) Priority: 06.02.2020 JP 2020018735
(43) Date of publication of application: 11.08.2021
(73) Proprietor: TOYOTA JIDOSHA KABUSHIKI KAISHA, Toyota-shi, Aichi-ken, 471-8571 (JP)
(72) Inventor: HAGA, Nobuyasu, Aichi-ken, 471-8571, (JP)
(74) Representative: J A Kemp LLP

(56) References cited:
- EP-A1- 1 995 123
- EP-A1- 3 376 585
- US-A1- 2015 355 288

## Description

### BACKGROUND

### Technical Field

The present disclosure relates to a battery degradation evaluation system for evaluating degradation of a battery such as an auxiliary battery of a vehicle or the like, a battery degradation assessment method, and a non-transitory storage medium storing a battery degradation assessment program.

### Related Art

EP 1 995 123A describes a battery state determining apparatus which can determine a battery state of a lead battery from an engine starting voltage accurately considering influence of a temperature of a vehicle. An engine starting voltage obtained by correcting an engine starting voltage of a lead battery at an engine starting time is calculated based upon an open-circuit voltage and a temperature of a vehicle, a battery determination voltage representing a voltage of the lead battery at an engine starting time when a growth rate of internal resistance of the lead battery reaches a predetermined value from the open-circuit voltage is calculated , and a battery state of the lead battery is determined by determining whether an engine starting voltage belongs to a predetermined region on a characteristic map. A temperature of the lead battery measured after at least a predetermined time elapsing from engine stopping is regarded as temperature of the vehicle so that the engine starting voltage is calculated. EP 3 376 585A describes a battery safety evaluation apparatus which includes a battery characteristic estimator, a heat amount estimator and safety index calculator. The battery characteristic estimator estimates an estimation value of an inner state parameter of a first battery on the basis of data on voltage and current of the first battery measured in charging or discharging. The heat amount estimator estimates a heat amount of the first battery upon change of an external temperature on the basis of first reference data which is at least indicating relationship between a heat amount of a secondary battery and the external temperature and is set to correspond to the first battery on the basis of the estimation value. The safety index calculator calculates a safety index regarding a temperature of the first battery upon change of the external temperature on the basis of the estimated heat amount. US 2015/355288A describes a secondary battery degradation determination method and a secondary battery degradation determination device which can detect degradation of a secondary battery in advance even before an engine starts. When it is determined that a vehicle is in a stop state, a stable-state open-circuit voltage is measured and internal resistance is calculated. On the other hand, when it is determined that a starter is operated, a maximum discharge current value is measured and a maximum discharge current value is updated. A minimum voltage is calculated. The stable-state open-circuit voltage and the minimum voltage are compared with predetermined threshold values to perform the degradation determination of a secondary battery. Japanese Patent Application Laid-Open (JP-A) No. 2018-179733 proposes a battery life assessment device including: a storage unit that stores usage durations of a battery that are measured at time intervals and measured values of a degradation index that are measured at the time intervals, the degradation index indicating degradation of the battery; and a processing unit that assesses a life of the battery. Based on the usage durations of the battery and the measured values of the degradation index, the processing unit finds changes over time of the degradation index. Based on the changes over time of the degradation index, the processing unit finds a prediction function of the degradation index for the individual battery. Based on the degradation index prediction function, the processing unit finds predicted values of the degradation index, and based on the predicted value of the degradation index, the processing unit assesses the life of the battery.

A state quantity of a battery such as voltage, resistance or the like varies dependent on temperature and current or the like of the battery. However, for example, the technology disclosed in JP-A No. 2018-179733 gives no consideration to a state quantity such as voltage, resistance or the like of a battery varying dependent on temperature, current or the like of the battery. Therefore, there is scope for improvement in that evaluation accuracy may decline when unmodified state quantities are used to evaluate degradation of a battery.

### SUMMARY

The present invention provides a battery degradation evaluation device, a battery degradation evaluation method and a battery degradation evaluation program that may accurately evaluate degradation of a battery.

To achieve the object described above, a battery degradation evaluation system according to a first aspect is defined in appended claim 1.

According to the first aspect, the acquisition section acquires the state quantity of the battery. The acquired state quantity is a physical quantity that changes in association with degradation of the battery. For example, voltage, resistance, temperature and the like of the battery can be mentioned as examples.

In a case in which the state quantity acquired by the acquisition section correlates with the physical quantity relating to temperature of the battery, the correction section corrects the state quantity.

The evaluation section evaluates degradation of the battery based on the state quantity that has been corrected by the correction section. Thus, because the state quantity that correlates with the physical quantity relating to temperature of the battery is corrected and degradation of the battery is evaluated, degradation of the battery may be evaluated more accurately than in a situation in which an unmodified state quantity is used to evaluate battery degradation.

As in a second aspect, the correction section may correct the state quantity with a correction amount that differs in accordance with a usage time of the battery. Thus, the effects of degradation may be taken into account, and cases of chances to identify degradation being missed due to correction may be suppressed.

As in a third aspect, the correction section may correct the state quantity with a pre-specified correction amount in accordance with a magnitude of the state quantity. Thus, the effects of degradation may be taken into account, and cases of chances to identify degradation being missed due to correction may be suppressed.

In a case in which the state quantity does not correlate with the physical quantity, the evaluation section evaluates degradation of the battery based on the state quantity acquired by the acquisition section. Thus, degradation of the battery may be evaluated without an unnecessary correction being performed.

As in a fourth aspect, the acquisition section may acquire the physical quantity. As in a fifth aspect, an estimation section that estimates the physical quantity may be further included. Thus, the estimation section may estimate the physical quantity.

As in a sixth aspect, the correction section may correct the state quantity in a case in which a correlation coefficient of the state quantity and the physical quantity is at least a pre-specified value. Alternatively, as in an seventh aspect, the correction section may compare respective values of the state quantity and the physical quantity with average values of the state quantity and the physical quantity in a pre-specified period, judge a correlation of the state quantity with the physical quantity, and correct the state quantity.

As in a eighth aspect, the state quantity that the acquisition section acquires may be detected by a sensor mounted at the vehicle.

As in a ninth aspect, the present invention is a computer-implemented battery degradation evaluation method as defined in appended claim 9.

Alternatively, as in a tenth aspect, the present invention is a computer program as defined in appended claim 12.

According to the present invention as described above, a battery degradation evaluation device, computer implemented battery degradation evaluation method, and a computer program may be provided that may accurately evaluate degradation of a battery.

### BRIEF DESCRIPTION OF THE DRAWINGS

Exemplary embodiments of the present invention will be described in detail based on the following figures, wherein:
Fig. 1 is a diagram showing schematic structures of a battery degradation evaluation system according to a present exemplary embodiment;
Fig. 2 is a functional block diagram showing structures of an on-board device and a center of the battery degradation evaluation system according to the present exemplary embodiment;
Fig. 3 is a diagram showing an example of data of voltages and temperatures of a battery;
Fig. 4 is a diagram for describing an example of, for a vehicle in which a temperature of a battery cannot be acquired, estimating the battery temperature from date data of evaluation object data that is a voltage;
Fig. 5 is a diagram for describing correction in accordance with whether or not there is a correlation between temperature variations of a battery and a state quantity of the battery;
Fig. 6 is a diagram showing a specific example of obtaining a correlation coefficient between temperature variations of a battery and the state quantity of the battery, and performing correction;
Fig. 7 is a diagram showing a specific example of evaluating a correlation between temperature variations of a battery and the state quantity of the battery from matches of high-low relationships relative to yearly average values, and performing correction;
Fig. 8 is a diagram showing an example of correction amounts at a data correction processing section;
Fig. 9 is a diagram showing an example of calculation of a degradation probability by a probability calculation section;
Fig. 10 is a flowchart showing an example of a flow of processing that is carried out by a data correction section of the center of the battery degradation evaluation system according to the present exemplary embodiment;
Fig. 11 is a flowchart showing an example of a flow of processing that is carried out by a data operations section of the center of the battery degradation evaluation system according to the present exemplary embodiment;
Fig. 12 is a diagram showing schematic structures of a degradation evaluation system when a portable terminal is employed as a communications device;
Fig. 13 is a functional block diagram showing structures provided at a portable terminal with functions of the center; and
Fig. 14 is a block diagram showing hardware structures of the degradation evaluation system according to the present exemplary embodiment.

### DETAILED DESCRIPTION

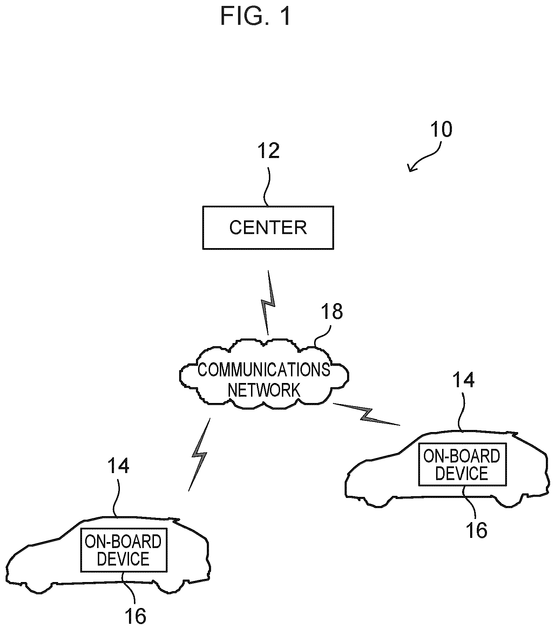

Below, an example of an embodiment of the present invention is described in detail with reference to the attached drawings. Fig. 1 is a diagram showing schematic structures of a battery degradation evaluation system according to the present exemplary embodiment.

In a battery degradation evaluation system 10 according to the present exemplary embodiment, an on-board device 16 mounted at a vehicle 14 is connected with a center 12 via a communications network 18. In the battery degradation evaluation system 10 according to the present exemplary embodiment, state quantities of batteries mounted at multiple on-board devices 16 are sent to the center 12, and the center 12 evaluates degradation of the batteries. The center 12 employs big data of state quantities of batteries gathered from multiple vehicles and machine learning based on artificial intelligence (AI) to evaluate degradation of the batteries, using the state quantities of the batteries as input values.

In the present exemplary embodiment, a case of application to, for example, an auxiliary lead storage battery of the vehicle 14 is described. The state quantity is a state quantity representing a state of a battery. In particular, the state quantity is a physical quantity that changes in association with degradation of the battery. For example, voltage, resistance, temperature and the like of the battery can be mentioned as examples. In the present exemplary embodiment, an example in which the state quantity is, as an example, a voltage of the battery is described.

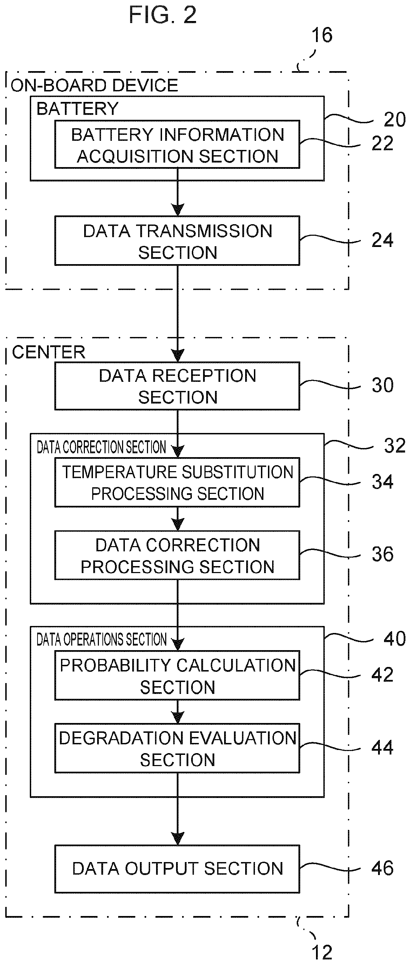

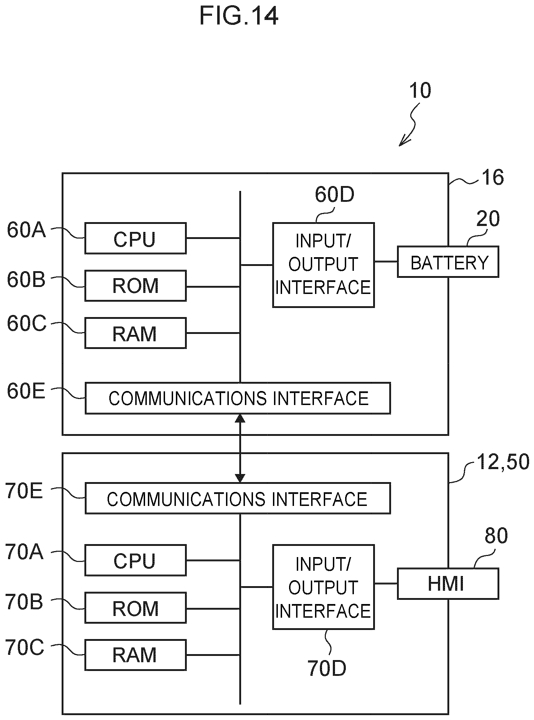

Fig. 2 is a block diagram showing structures of the on-board device 16 and center 12 of the battery degradation evaluation system 10 according to the present exemplary embodiment. Fig. 14 is a block diagram showing hardware structures of the battery degradation evaluation system 10 according to the present exemplary embodiment.

As shown in Fig. 14, the on-board device 16 is constituted by an ordinary microcomputer including a central processing unit (CPU) 60A, read-only memory (ROM) 60B and random access memory (RAM) 60C that serve as memory, an input/output interface 60D, a communications interface 60E and so forth. The CPU 60A functions as a battery information acquisition section 22 and a data transmission section 24.

As shown in Fig. 2, the battery information acquisition section 22 acquires state quantities of a battery 20 mounted at the vehicle 14, which are voltages of a battery 20, to serve as battery information. The battery information acquisition section 22 acquires the voltages of the battery 20 with, for example, a voltage sensor. The battery information acquisition section 22 may be further provided with a temperature sensor that detects a temperature of the battery 20 and may acquire temperatures of the battery 20.

The data transmission section 24 sends the battery information acquired by the battery information acquisition section 22 to the center 12 via the communications network 18.

As shown in Fig. 14, the center 12 is constituted by an ordinary computer including a CPU 70A that serves as a processor, ROM 70B and RAM 70C that serve as memory, an input/output interface 70D, a communications interface 70E and so forth. The input/output interface 70D may be connected with a human-machine interface (HMI) such as a monitor 80 provided with a touch panel or the like. The CPU 70A functions as a data reception section 30, a data correction section 32, a data operations section 40 and a data output section 46.

As shown in Fig. 2, the data reception section 30 acquires the battery information representing the state quantities of the battery 20 from the on-board device 16 of the vehicle 14, by receiving the battery information sent from the data transmission section 24 of the on-board device 16 via the communications network 18. Below, a case in which the battery information is a state quantity of the battery 20 is described.

The data correction section 32 features functions of a temperature substitution processing section 34 and a data correction processing section 36. The data correction section 32 performs processing on the battery information received by the data reception section 30 to correct for a variation amount that is dependent on a temperature of the battery 20.

When there is no sensor at the vehicle 14 to detect the temperature of the battery 20 and temperature information cannot be acquired, the temperature substitution processing section 34 estimates a temperature of the battery 20 to be used in a degradation evaluation or in degradation evaluation learning.

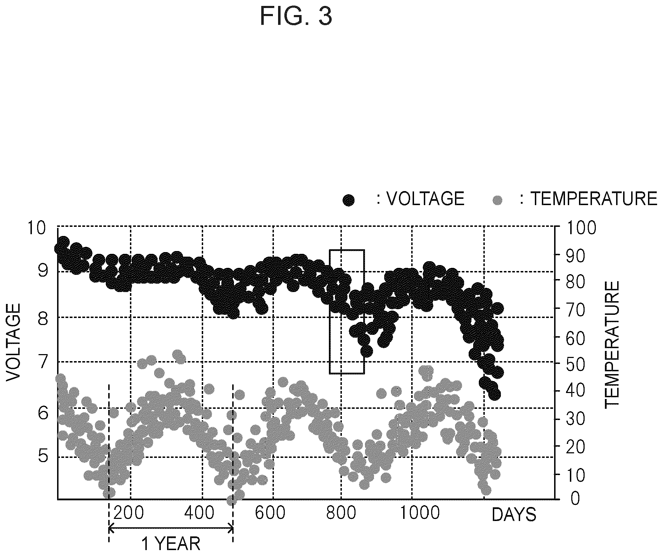

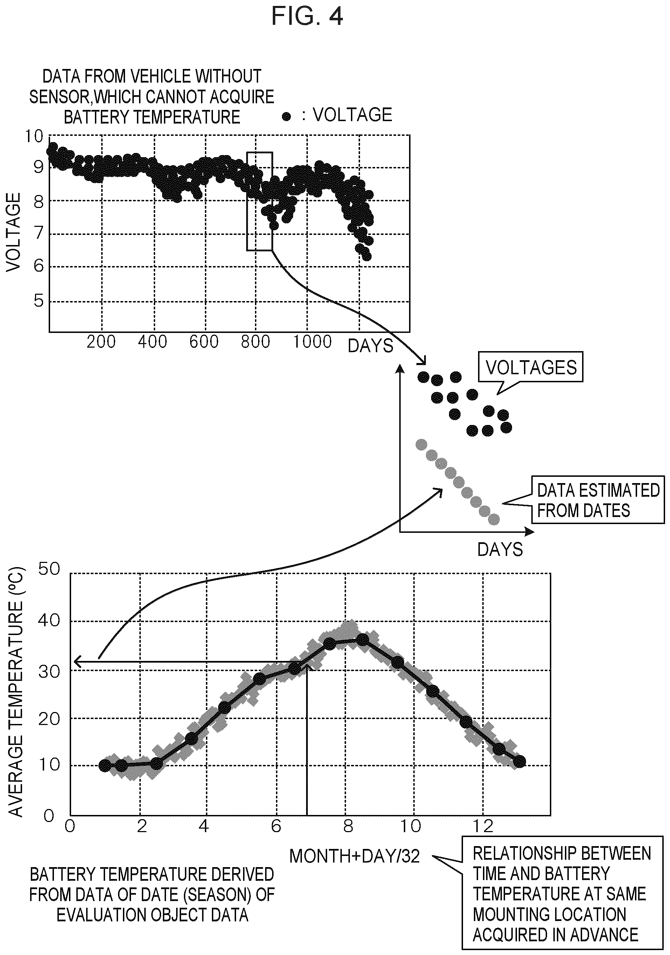

In a situation in a luggage compartment or the like in which the battery 20 is distant from a heat-generating body such as an engine or the like, the temperature of the battery 20 is dependent on ambient air. In this situation, as illustrated in Fig. 3, the temperature of the battery 20 repeatedly varies up and down in a periodic manner in accordance with the season. Therefore, provided a relationship between local seasons of the vehicle 14 and ambient air is known, the temperature of the battery 20 may be roughly estimated. Accordingly, the temperature substitution processing section 34 estimates the temperature of the battery 20. More specifically, as illustrated in Fig. 4, a relationship between time and temperature of another of the battery 20 in a similar mounting location is acquired beforehand. When data (a voltage, serving as a state quantity) is acquired from a vehicle that has no sensor and cannot acquire the temperature of the battery 20, the temperature of the battery 20 is estimated from data of a date (season) of the voltage serving as the state quantity, which is evaluation object data. The date data serves as a physical quantity relating to the temperature of the battery 20.

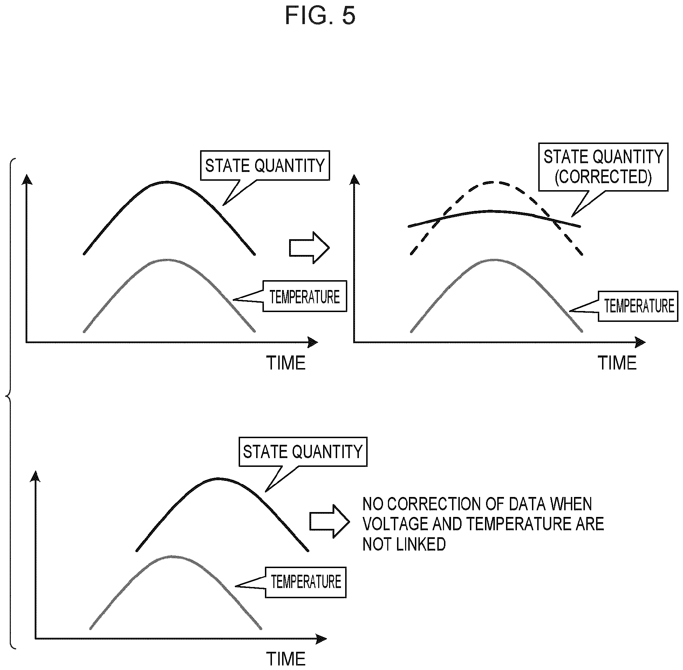

The state quantity of the battery 20 is affected by the temperature of the battery 20, and the battery temperature is affected by the ambient air. Accordingly, the data correction processing section 36 corrects variations of the state quantity that have correlations with variations of the ambient air to remove the effects of the ambient air. In the present exemplary embodiment, variations in the state quantity that, as illustrated in the upper part of Fig. 5, correlate with variations in the temperature of the battery 20 or with variations in ambient air temperature, which serves as a physical quantity relating to the temperature of the battery 20, are corrected by a computation expression (a logical expression) based on a mechanism of the correlations. As shown in the lower part of Fig. 5, correction is suspended for variations in the state quantity that do not have a correlation. The logical expression utilizes, for example, V=OCV-IR(T) in the case of voltage. In this expression, OCV represents the open circuit voltage, I represents current, and R(T) represents a resistance value corresponding to the temperature at the time of acquisition of the state quantity.

For a correlation between battery temperature, serving as a physical quantity relating to temperature of the battery 20, and the state quantity, a method of obtaining a correlation coefficient between the two quantities, a method of evaluating a correlation from matches of high-low relationships relative to yearly average values, and so forth are available.

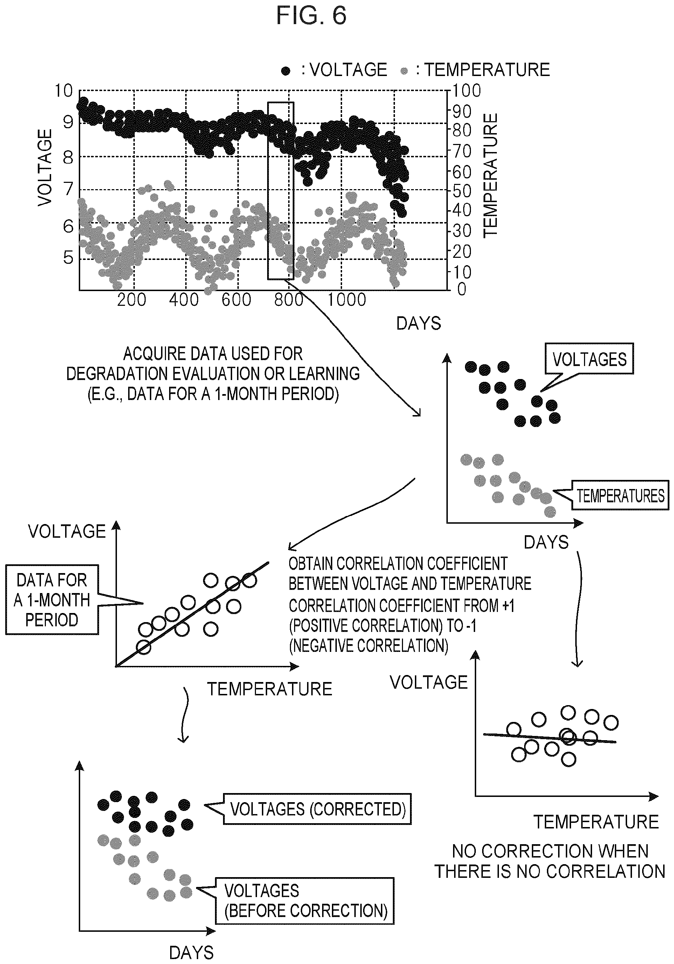

For example, in a case in which a correlation coefficient is to be obtained, as shown in Fig. 6, data used for degradation evaluation or for learning (for example, data corresponding to a one-month period) is acquired and a correlation between voltage and temperature is obtained. In a case in which the correlation coefficient is at least a pre-specified threshold (for example, 0.8), it is judged that there is a correlation and voltage values are corrected based on the computation expression described above. On the other hand, when it is judged that there is no correlation, correction is suspended. Therefore, of variations in the state quantity, only variation amounts due to temperature may be corrected, and variations in the state quantity corresponding to degradation of the battery 20 may be clearly identified. As a result, degradation evaluation accuracy may be improved.

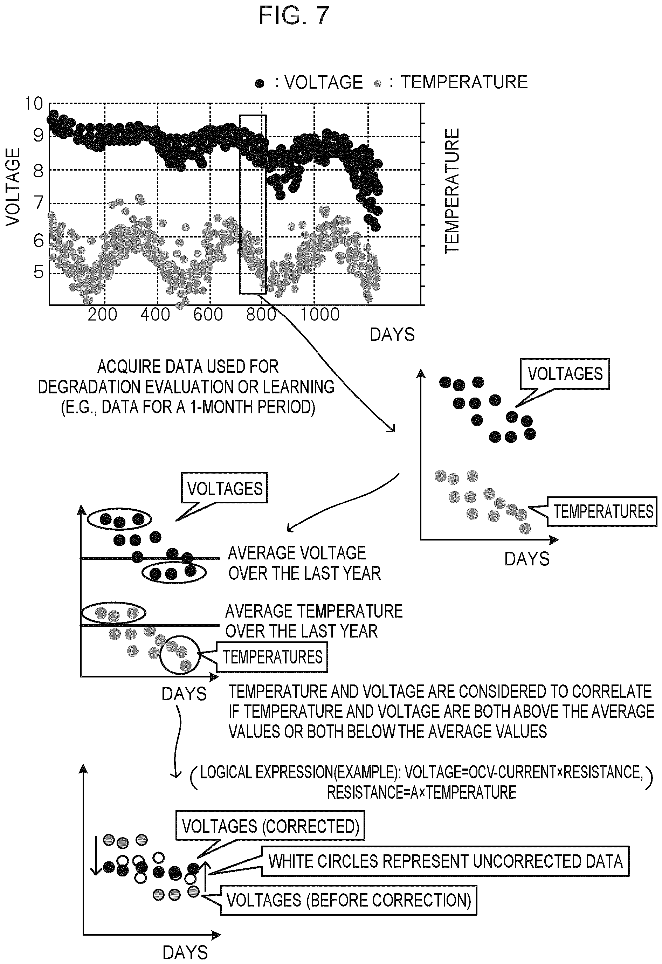

Alternatively, in a case of evaluation from matches of high-low relationships relative to yearly average values, as shown in Fig. 7, data used for degradation evaluation or for learning (for example, data corresponding to a one-month period) is acquired, and an average voltage over the last year and an average temperature over the last year are calculated to serve as physical quantities relating to temperature of the battery 20. In this method, voltage and temperature pairs that are both above the average values or both below the average values are considered to correlate, and the state quantity is corrected using a logical expression.

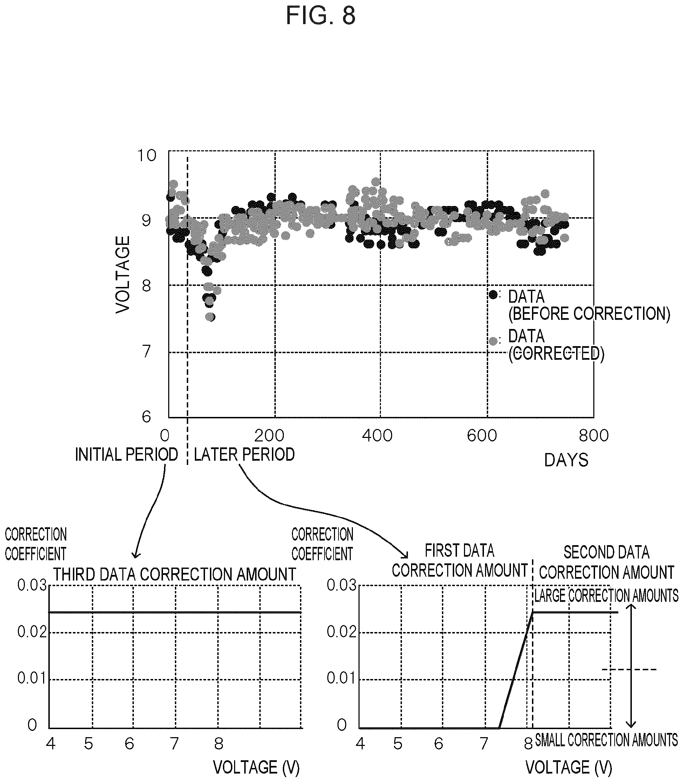

Because the state quantity of a battery varies in accordance with degradation, in a case in which the state quantity is used to estimate degradation, there may be cases of chances to identify degradation being missed due to correction. Accordingly, when the data correction processing section 36 corrects a state quantity that is to be used as an input for degradation evaluation, the data correction processing section 36 determines a correction amount taking into account the effects of degradation. More specifically, correction amounts are determined using a data map of state quantities and correction coefficients. If the state quantity is voltage, correction amounts in a low-voltage range are smaller than in other voltage ranges, and if the state quantity is resistance, correction amounts in a high-resistance range are smaller than in other resistance ranges. For example, as shown in Fig. 8, correction amounts take into account time, which serves as a physical quantity relating to temperature of the battery 20. A correction coefficient when the time is in a pre-specified initial period (for example, a period of one or two years with no degradation) is set to a correction coefficient of a pre-specified third data correction amount, which applies maximum correction. In a later period subsequent to the initial period, correction coefficients are deployed in accordance with magnitudes of the state quantity. In the example in Fig. 8, an example is depicted in which correction amounts are smaller in a low-voltage range. In the illustrated example, a correction amount in the low-voltage range is set to a correction coefficient of a first data correction amount and a correction amount in a high-voltage range is set to a correction coefficient of a second data correction amount.

The data operations section 40 features functions of a probability calculation section 42 and a degradation evaluation section 44. The data operations section 40 evaluates degradation of each battery 20 based on the state quantities acquired from the on-board device 16.

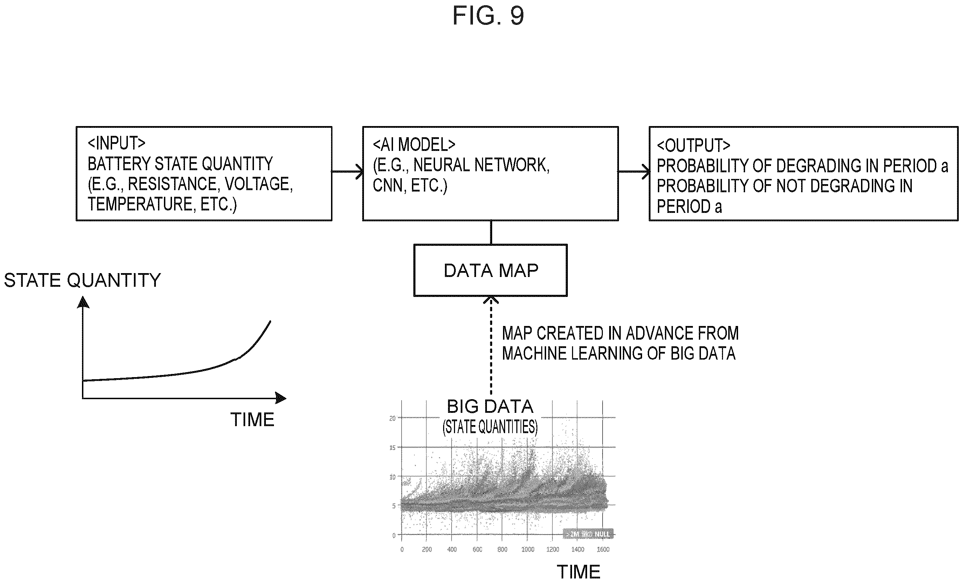

As shown in Fig. 9, the probability calculation section 42 creates a data map in advance through machine learning based on an AI model such as a neural network, a convolution neural network (CNN) or the like, using degradation data of state quantities acquired beforehand as training data. The data map that has been created is used to calculate a degradation probability, with the state quantity of the battery 20 as an input. The degradation probability that is calculated is, for example, a probability of degrading in a pre-specified period a, the probability of not degrading in the period a, or the like.

Based on the calculation result from the probability calculation section 42, the degradation evaluation section 44 evaluates whether the battery 20 has degraded by making a determination as to whether the state quantity meets a pre-specified degrading condition. For example, the degradation evaluation section 44 evaluates degradation by making a determination as to whether a probability of degrading calculated by the probability calculation section 42 is at least a pre-specified threshold value.

The data output section 46 sends an evaluation result from the degradation evaluation section 44 to the on-board device 16 of the vehicle 14 from which the state quantity was acquired. Hence, a degradation evaluation result of the battery 20 may be reported by the on-board device 16.

Herein, the battery information acquisition section 22 or data reception section 30 corresponds to an acquisition section, the data correction section 32 corresponds to a correction section, the data operations section 40 corresponds to an evaluation section, and the temperature substitution processing section 34 corresponds to an estimation section.

Now, specific processing that is carried out at the center 12 of the battery degradation evaluation system 10 according to the present exemplary embodiment configured as described above is described.

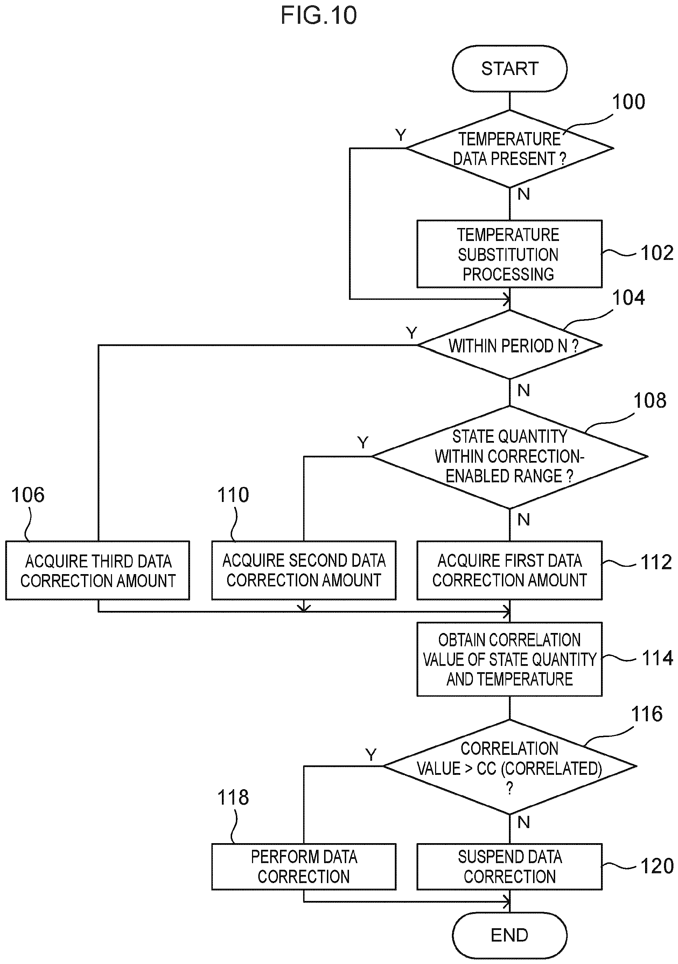

Fig. 10 is a flowchart showing an example of a flow of processing that is carried out by the data correction section 32 of the center 12 of the battery degradation evaluation system 10 according to the present exemplary embodiment. The processing in Fig. 10 starts, for example, when the data reception section 30 receives a state quantity from the on-board device 16.

In step 100, the temperature substitution processing section 34 makes a determination as to whether temperature data is present. This determination is a determination as to whether temperature data is received from the on-board device 16 together with the state quantity. If the result of this determination is negative, the data correction section 32 proceeds to step 102, and if the result is affirmative, the data correction section 32 proceeds to step 104.

In step 102, the temperature substitution processing section 34 performs temperature substitution processing, and the data correction section 32 proceeds to step 104. For example, as shown in Fig. 4, a relationship between time and temperature of the battery 20 is acquired beforehand, and the temperature substitution processing section 34 estimates the battery temperature from date data (the season) of the state quantity that is the evaluation object data.

In step 104, the data correction processing section 36 makes a determination as to whether the time is within a pre-specified period N. This determination is, for example, a determination as to whether the time is within an initial period of one or two years or the like. If the result of this determination is affirmative, the data correction section 32 proceeds to step 106, and if the result is negative, the data correction section 32 proceeds to step 108.

In step 106, the data correction processing section 36 acquires the third data correction amount, and the data correction section 32 proceeds to step 114. The third data correction amount obtains a correction coefficient corresponding to the initial period shown in Fig. 8. In the present exemplary embodiment, as described above, the third data correction amount is a correction coefficient that applies maximum correction.

In step 108, the data correction processing section 36 makes a determination as to whether the state quantity is within a correction-enabled range. This determination is a determination as to whether the voltage serving as the state quantity, which corresponds to the later period shown in Fig. 8, is a voltage for which the correction coefficient is to be a correction coefficient for a maximum correction amount. If the result of this determination is affirmative, the control section 12 proceeds to step 110, and if the result is negative, the control section 12 proceeds to step 112.

In step 110, the data correction processing section 36 acquires the second data correction amount, and the data correction section 32 proceeds to step 114. The second data correction amount is a correction coefficient corresponding to the high-voltage range in the later period shown in Fig. 8. In the present exemplary embodiment, the same as the third data correction amount, the second data correction amount is the correction coefficient that applies maximum correction.

In step 112, the data correction processing section 36 acquires the first data correction amount, and the data correction section 32 proceeds to step 114. The first data correction amount is a correction coefficient corresponding to the low-voltage range in the later period shown in Fig. 8. As shown in Fig. 8, the first data correction amount is, depending on the voltage, a value from zero to the maximum correction coefficient.

In step 114, the data correction processing section 36 obtains a correlation value between the state quantity and temperature, and the data correction section 32 proceeds to step 116. That is, in the present exemplary embodiment, a correlation value of temperature with the voltage serving as the state quantity is obtained.

In step 116, the data correction processing section 36 makes a determination as to whether the correlation value is greater than a pre-specified threshold CC. In other words, the data correction processing section 36 makes a determination as to whether there is a correlation. If the result of this determination is affirmative, the data correction section 32 proceeds to step 118, and if the result is negative, the data correction section 32 proceeds to step 120.

In step 118, the data correction processing section 36 uses the correction coefficient acquired in step 106, step 110 or step 112 to correct the voltage serving as the state quantity, and this sequence of processing by the data correction section 32 is ended.

Alternatively, in step 120, the data correction processing section 36 suspends data correction, and this sequence of processing by the data correction section 32 is ended.

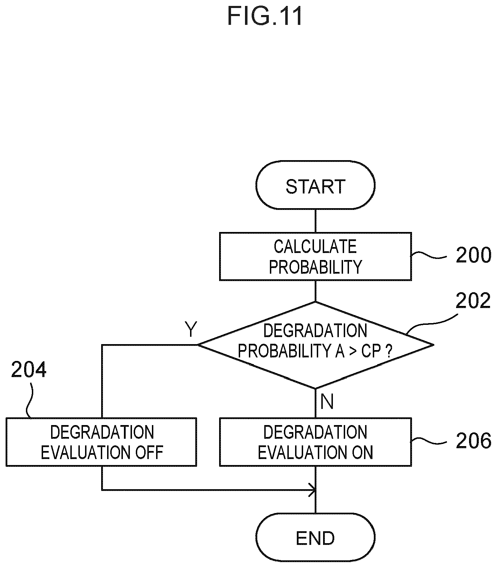

Now, processing that is carried out by the data operations section 40, which is carried out following the processing by the data correction section 32, is described. Fig. 11 is a flowchart showing an example of a flow of the processing carried out by the data operations section 40 of the center 12 of the battery degradation evaluation system 10 according to the present exemplary embodiment. The processing in Fig. 11 starts, for example, when the processing by the data correction section 32 in Fig. 10 ends.

In step 200, the probability calculation section 42 calculates a degradation probability of the battery 20, and the data operations section 40 proceeds to step 202. That is, the data map created beforehand is used to calculate the degradation probability, with the state quantity of the battery 20 as an input. The degradation probability that is calculated in this step is a probability of degrading in a pre-specified period a, but may be the probability of not degrading in the period a.

In step 202, the degradation evaluation section 44 makes a determination as to whether the calculated degradation probability A is greater than a pre-specified threshold CP. If the result of this determination is affirmative, the data operations section 40 proceeds to step 204, and if the result is negative, the data operations section 40 proceeds to step 206.

In step 204, the degradation evaluation section 44 evaluates that the battery is degrading and sets degradation evaluation to on, and this sequence of processing by the data operations section 40 ends.

Alternatively, in step 206, the degradation evaluation section 44 evaluates that the battery is not degrading and sets the degradation evaluation to off, and this sequence of processing by the data operations section 40 ends.

By carrying out this processing, the present exemplary embodiment may correct state quantities that correlate with temperature changes of the battery 20 and not correct state quantities that do not correlate. Thus, the present exemplary embodiment may suppress the effects of temperature changes on degradation evaluation accuracy of the battery 20.

When a state quantity is corrected, a correction amount is determined in accordance with a usage time of the battery 20 and the state quantity. Thus, because the effect of degradation is taken into consideration, a case of a degradation evaluation period being delayed due to correction may be suppressed.

Even when there is no sensor that detects the temperature of the battery 20 at the vehicle 14 and temperature information cannot be acquired, the temperature substitution processing section 34 may estimate the temperature. Thus, an increase in costs due to the addition of a temperature sensor may be suppressed, and a reduction in evaluation degradation accuracy because temperature information cannot be acquired may be suppressed.

In the exemplary embodiment described above, an example is described in which the second data correction amount and the third data correction amount are the same correction coefficient, but this is not limiting; the second data correction amount and the third data correction amount may be different correction coefficients. The correction coefficients shown in Fig. 8 are examples and are not limiting.

In the exemplary embodiment described above, an example is described in which the data correction processing section 36 applies correction in accordance with a correlation between the state quantity and temperature, but this is not limiting. For example, it is known that state quantities such as voltage, resistance and the like are dependent on current values. Ordinarily, because resistance of the battery 20 is dependent on temperature, a current load in the vehicle 14 may be controlled in accordance with temperature. In this situation, the current load varies with a certain period. Therefore, similar processing may be performed with current values replacing the temperatures. Similarly, an alternative physical quantity that changes in accordance with temperature, current or the like may be used.

In the exemplary embodiment described above, voltage, resistance, temperature and the like of the battery 20 are mentioned as examples of the state quantity, but the state quantity is not limited thus. For example, a current or power relating to the battery 20, a two-dimensionally obtained state of charge (SOC) or the like, or a quantity in which these quantities are multiplied or added may prospectively be the state quantity. A prospective state quantity that is employed may be a single quantity and may be plural quantities. Which state quantity is most appropriate may vary in accordance with conditions, required accuracy and the like. Accordingly, it is sufficient to select the state quantity as appropriate.

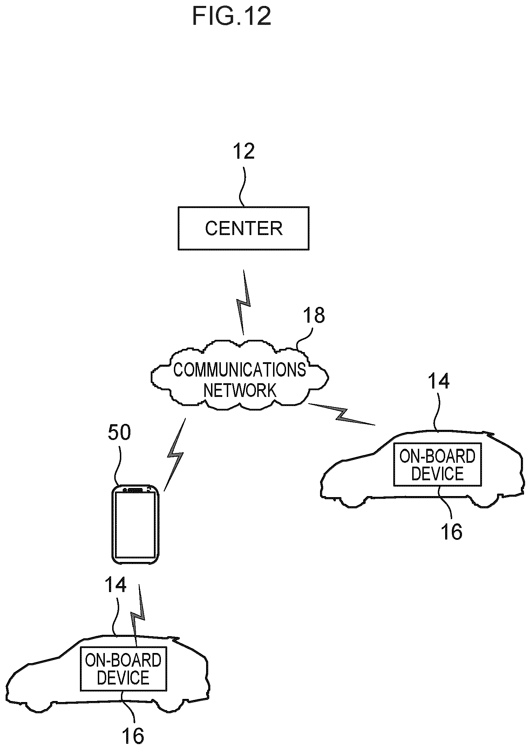

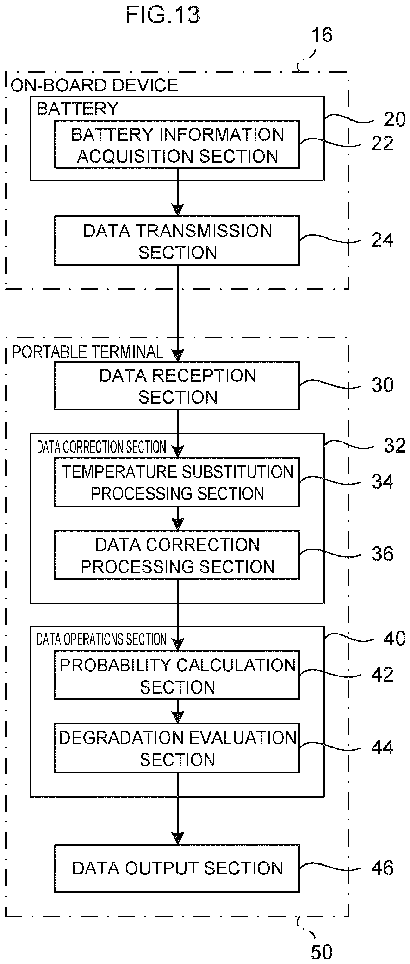

In the exemplary embodiment described above, an example is described in which a communications device is provided at the vehicle 14 for communicating with the center 12, but this is not limiting. For example, as shown in Fig. 12, a portable terminal 50 such as a smartphone carried by a vehicle occupant or the like may be employed as the communications device. Alternatively, as shown in Fig. 13, the functions of the center 12 shown in Fig. 2 may be provided at the portable terminal 50, and processing to evaluate degradation of the battery 20 may be carried out by the portable terminal 50. In this configuration, the portable terminal 50 is equipped with hardware structures similar to the hardware structures of the center 12, as shown in Fig. 14.

In the exemplary embodiment described above, an example is described in which degradation of the battery 20 is evaluated using big data and machine learning based on an AI model, but this is not limiting. For example, an evaluation method may be employed that uses single regression analysis, multiple regression analysis or the like. Alternatively, a degradation evaluation method may be employed that uses small-quantity data and a physical model. Alternatively again, a degradation evaluation method may be employed that uses both machine learning and a physical model.

In the exemplary embodiment described above, an example is described in which the data correction processing section 36 uses a data map of state quantities and correction coefficients to determine the correction amount, but this is not limiting. For example, a calculation expression may be used instead of a data map. Further, a correction coefficient may be determined not just from the state quantity and time. Any factors that affect loads on the battery 20 (for example, usage states of the vehicle 14, running states and the like) may be utilized.

In the exemplary embodiment described above, an example is described in which, as an example of a method for estimating temperature, the temperature substitution processing section 34 estimates the temperature of the battery 20 from date data. However, a temperature estimation method is not limited thus. For example, a value other than time that is linked with temperature may be utilized, provided that value interrelates with temperature. For example, when the battery 20 is installed in an engine compartment, the temperature of the battery 20 varies with an engine temperature, such as an engine water temperature or the like. Thus, the temperature of the battery 20 may be estimated from the engine water temperature. In this configuration, an engine temperature detection period, in units of hours or the like, is a shorter period than a date data detection period. A calculation expression may also be utilized as a method for estimating temperature.

The processing executed by the center 12 according to the exemplary embodiment described above is described as software processing that is implemented by a program being executed, but this is not limiting. For example, the processing may be carried out by hardware such as a graphics processing unit (GPU), application-specific integrated circuit (ASIC), field-programmable gate array (FPGA) or the like. Alternatively, the processing may combine both software and hardware. Further, if the processing is implemented in software, the program may be memorized in any of various non-transitory storage media and distributed.

The present disclosure is not limited by the above recitations. In addition to the above recitations, it will be clear that numerous modifications may be embodied within a technical scope not departing from the appended claims.

## Claims

1. A battery degradation evaluation system (10) comprising:
an acquisition section (22, 30) configured to acquire a state quantity of a battery (20);
a correction section (32) configured, in a case in which the state quantity acquired by the acquisition section (22, 30) correlates with a physical quantity relating to a temperature of the battery (20), to correct the state quantity; and
an evaluation section (40) configured to evaluate degradation of the battery (20) based on the state quantity corrected by the correction section (32); wherein
in a case in which the state quantity does not correlate with the physical quantity, the evaluation section (40) is configured to evaluate degradation of the battery (20) based on the state quantity acquired by the acquisition section (22, 30).

2. The battery degradation evaluation system (10) according to claim 1, wherein the correction section (32) corrects the state quantity with a correction amount that differs in accordance with a usage time of the battery (20).

3. The battery degradation evaluation system (10) according to claim 1 or claim 2, wherein the correction section (32) corrects the state quantity with a pre-specified correction amount in accordance with a magnitude of the state quantity.

4. The battery degradation evaluation system (10) according to any one of claims 1 to 3, wherein the acquisition section (22, 30) further acquires the physical quantity.

5. The battery degradation evaluation system (10) according to any one of claims 1 to 3, further comprising an estimation section (34) that estimates the physical quantity.

6. The battery degradation evaluation system (10) according to any one of claims 1 to 5, wherein the correction section (32) corrects the state quantity when a correlation coefficient of the state quantity and the physical quantity is at least a pre-specified value.

7. The battery degradation evaluation system (10) according to any one of claims 1 to 5, wherein the correction section (32) compares respective values of the state quantity and the physical quantity with average values of the state quantity and the physical quantity in a pre-specified period, judges a correlation of the state quantity with the physical quantity, and corrects the state quantity.

8. The battery degradation evaluation system (10) according to any one of claims 1 to 7, wherein the state quantity acquired by the acquisition section (22, 30) is detected by a sensor installed at a vehicle (14).

9. A computer-implemented battery degradation evaluation method comprising:
acquiring a state quantity of a battery (20);
in a case in which the acquired state quantity correlates with a physical quantity relating to a temperature of the battery (20), correcting the state quantity;
evaluating degradation of the battery based on the corrected state quantity;
in a case in which the state quantity does not correlate with the physical quantity, evaluating degradation of the battery (20) based on the state quantity acquired by the acquiring (22, 30).

10. The battery degradation evaluation method according to claim 9, wherein the correcting includes correcting the state quantity with a correction amount that differs in accordance with a usage time of the battery (20).

11. The battery degradation evaluation method according to claim 9 or claim 10, wherein the correcting includes correcting the state quantity with a pre-specified correction amount in accordance with a magnitude of the state quantity.

12. A computer program comprising instructions which, when the program is executed by a computer, cause the computer to carry out battery degradation evaluation processing, the battery degradation evaluation processing comprising:
acquiring a state quantity of a battery (20);
in a case in which the acquired state quantity correlates with a physical quantity relating to a temperature of the battery (20), correcting the state quantity;
evaluating degradation of the battery based on the corrected state quantity; and
in a case in which the state quantity does not correlate with the physical quantity, evaluating degradation of the battery (20) based on the state quantity acquired by the acquiring (22, 30).

13. The program according to claim 12, wherein the correcting further comprises correcting the state quantity with a correction amount that differs in accordance with a usage time of the battery (20).

14. The program according to claim 12 or claim 13, wherein the correcting further comprises correcting the state quantity with a pre-specified correction amount in accordance with a magnitude of the state quantity.

## Patentansprüche

1. System (10) für die Bewertung der Verschlechterung einer Batterie, umfassend:
einen Erfassungsbereich (22, 30), der dazu konfiguriert ist, eine Zustandsgröße einer Batterie (20) zu erfassen;
einen Korrekturbereich (32), der dazu konfiguriert ist, in einem Fall, in dem die Zustandsgröße, die durch den Erfassungsbereich (22, 30) erfasst wird, mit einer physikalischen Größe korreliert, die sich auf eine Temperatur der Batterie (20) bezieht, die Zustandsgröße zu korrigieren; und
einen Auswertungsbereich (40), der dazu konfiguriert ist, eine Verschlechterung der Batterie (20) auf Grundlage der durch den Korrekturbereich (32) korrigierten Zustandsgröße auszuwerten; wobei
in einem Fall, in dem die Zustandsgröße nicht mit der physikalischen Größe korreliert, der Auswertungsbereich (40) dazu konfiguriert ist, die Verschlechterung der Batterie (20) auf Grundlage der von dem Erfassungsbereich (22, 30) erfassten Zustandsgröße auszuwerten.

2. System (10) für die Bewertung der Verschlechterung einer Batterie nach Anspruch 1, wobei der Korrekturbereich (32) die Zustandsgröße mit einem Korrekturbetrag korrigiert, der sich in Übereinstimmung mit einer Nutzungsdauer der Batterie (20) unterscheidet.

3. System (10) für die Bewertung der Verschlechterung einer Batterie nach Anspruch 1 oder 2, wobei der Korrekturbereich (32) die Zustandsgröße mit einem vorgegebenen Korrekturbetrag in Übereinstimmung mit einer Größe der Zustandsgröße korrigiert.

4. System (10) für die Bewertung der Verschlechterung einer Batterie nach einem der Ansprüche 1 bis 3, wobei der Erfassungsbereich (22, 30) ferner die physikalische Größe erfasst.

5. System (10) für die Bewertung der Verschlechterung einer Batterie nach einem der Ansprüche 1 bis 3, das ferner einen Schätzbereich (34) umfasst, der die physikalische Größe schätzt.

6. System (10) für die Bewertung der Verschlechterung einer Batterie nach einem der Ansprüche 1 bis 5, wobei der Korrekturbereich (32) die Zustandsgröße korrigiert, wenn ein Korrelationskoeffizient der Zustandsgröße und der physikalischen Größe wenigstens ein vorgegebener Wert ist.

7. System (10) für die Bewertung der Verschlechterung einer Batterie nach einem der Ansprüche 1 bis 5, wobei der Korrekturbereich (32) die jeweiligen Werte der Zustandsgröße und der physikalischen Größe mit Durchschnittswerten der Zustandsgröße und der physikalischen Größe in einem vorgegebenen Zeitraum vergleicht, eine Korrelation der Zustandsgröße mit der physikalischen Größe beurteilt, und die Zustandsgröße korrigiert.

8. System (10) für die Bewertung der Verschlechterung einer Batterie nach einem der Ansprüche 1 bis 7, wobei die von dem Erfassungsbereich (22, 30) erfasste Zustandsgröße von einem an einem Fahrzeug (14) installierten Sensor erkannt wird.

9. Computerimplementiertes Verfahren für die Bewertung der Verschlechterung einer Batterie, umfassend:
Erfassen einer Zustandsgröße einer Batterie (20);
in einem Fall, in dem die erfasste Zustandsgröße mit einer physikalischen Größe korreliert, die sich auf eine Temperatur der Batterie (20) bezieht, Korrigieren der Zustandsgröße;
Auswerten der Verschlechterung der Batterie auf Grundlage der korrigierten Zustandsgröße;
in einem Fall, in dem die Zustandsgröße nicht mit der physikalischen Größe korreliert, Auswerten der Verschlechterung der Batterie (20) auf Grundlage der durch das Erfassen (22, 30) erfassten Zustandsgröße.

10. Verfahren für die Auswertung der Verschlechterung einer Batterie nach Anspruch 9, wobei das Korrigieren das Korrigieren der Zustandsgröße mit einem Korrekturbetrag beinhaltet, der sich in Übereinstimmung mit der Nutzungsdauer der Batterie (20) unterscheidet.

11. Verfahren für die Auswertung der Verschlechterung einer Batterie nach Anspruch 9 oder 10, wobei das Korrigieren das Korrigieren der Zustandsgröße mit einem vorgegebenen Korrekturbetrag in Übereinstimmung mit einer Größe der Zustandsgröße beinhaltet.

12. Computerprogramm, umfassend Anweisungen, die, wenn das Programm von einem Computer ausgeführt wird, den Computer veranlassen, eine Verarbeitung für die Auswertung der Verschlechterung einer Batterie durchzuführen, wobei die Verarbeitung für die Auswertung der Verschlechterung einer Batterie umfasst:
Erfassen einer Zustandsgröße einer Batterie (20);
in einem Fall, in dem die erfasste Zustandsgröße mit einer physikalischen Größe korreliert, die sich auf eine Temperatur der Batterie (20) bezieht, Korrigieren der Zustandsgröße;
Auswerten der Verschlechterung der Batterie auf Grundlage der korrigierten Zustandsgröße;
in einem Fall, in dem die Zustandsgröße nicht mit der physikalischen Größe korreliert, Auswerten der Verschlechterung der Batterie (20) auf Grundlage der durch das Erfassen (22, 30) erfassten Zustandsgröße.

13. Programm nach Anspruch 12, wobei das Korrigieren ferner das Korrigieren der Zustandsgröße mit einem Korrekturbetrag umfasst, der sich in Übereinstimmung mit der Nutzungsdauer der Batterie (20) unterscheidet.

14. Programm nach Anspruch 12 oder 13, wobei das Korrigieren ferner das Korrigieren der Zustandsgröße mit einem vorgegebenen Korrekturbetrag in Übereinstimmung mit einer Größe der Zustandsgröße umfasst.

## Revendications

1. Système d'évaluation de dégradation de batterie (10) comprenant :
une section d'acquisition (22, 30) configurée pour acquérir une quantité d'état d'une batterie (20) ;
une section de correction (32) configurée, dans un cas où la quantité d'état acquise par la section d'acquisition (22, 30) est en corrélation avec une quantité physique relative à une température de la batterie (20), pour corriger la quantité d'état ; et
une section d'évaluation (40) configurée pour évaluer la dégradation de la batterie (20) sur la base de la quantité d'état corrigée par la section de correction (32) ;
dans lequel, dans un cas où la quantité d'état n'est pas en corrélation avec la quantité physique, la section d'évaluation (40) est configurée pour évaluer la dégradation de la batterie (20) sur la base de la quantité d'état acquise par la section d'acquisition (22, 30).

2. Système d'évaluation de dégradation de batterie (10) selon la revendication 1, dans lequel la section de correction (32) corrige la quantité d'état avec une quantité de correction qui diffère selon un temps d'utilisation de la batterie (20).

3. Système d'évaluation de dégradation de batterie (10) selon la revendication 1 ou la revendication 2, dans lequel la section de correction (32) corrige la quantité d'état avec une quantité de correction prédéfinie selon une amplitude de la quantité d'état.

4. Système d'évaluation de dégradation de batterie (10) selon l'une quelconque des revendications 1 à 3, dans lequel la section d'acquisition (22, 30) acquiert en outre la quantité physique.

5. Système d'évaluation de dégradation de batterie (10) selon l'une quelconque des revendications 1 à 3, comprenant en outre une section d'estimation (34) qui estime la quantité physique.

6. Système d'évaluation de dégradation de batterie (10) selon l'une quelconque des revendications 1 à 5, dans lequel la section de correction (32) corrige la quantité d'état lorsqu'un coefficient de corrélation de la quantité d'état et de la quantité physique est au moins une valeur pré-spécifiée.

7. Système d'évaluation de dégradation de batterie (10) selon l'une quelconque des revendications 1 à 5, dans lequel la section de correction (32) compare des valeurs respectives de la quantité d'état et de la quantité physique avec des valeurs moyennes de la quantité d'état et de la quantité physique dans une période pré-spécifiée, évalue une corrélation de la quantité d'état avec la quantité physique, et corrige la quantité d'état.

8. Système d'évaluation de dégradation de batterie (10) selon l'une quelconque des revendications 1 à 7, dans lequel la quantité d'état acquise par la section d'acquisition (22, 30) est détectée par un capteur installé sur un véhicule (14).

9. Procédé d'évaluation de dégradation de batterie mis en oeuvre par ordinateur comprenant :
l'acquisition d'une quantité d'état d'une batterie (20) ;
dans un cas où la quantité d'état acquise est en corrélation avec une quantité physique relative à une température de la batterie (20), la correction de la quantité d'état ;
l'évaluation de la dégradation de la batterie sur la base de la quantité d'état corrigée ;
dans un cas où la quantité d'état n'est pas en corrélation avec la quantité physique, l'évaluation de la dégradation de la batterie (20) sur la base de la quantité d'état acquise par l'acquisition (22, 30).

10. Procédé d'évaluation de dégradation de batterie selon la revendication 9, dans lequel la correction comprend la correction de la quantité d'état avec une quantité de correction qui diffère en fonction d'un temps d'utilisation de la batterie (20).

11. Procédé d'évaluation de dégradation de batterie selon la revendication 9 ou la revendication 10, dans lequel la correction comprend la correction de la quantité d'état avec une quantité de correction prédéfinie selon une amplitude de la quantité d'état.

12. Programme informatique comprenant des instructions qui, lorsque le programme est exécuté par un ordinateur, amènent l'ordinateur à effectuer un traitement d'évaluation de dégradation de batterie, le traitement d'évaluation de dégradation de batterie comprenant :
l'acquisition d'une quantité d'état d'une batterie (20) ;
dans un cas où la quantité d'état acquise est en corrélation avec une quantité physique relative à une température de la batterie (20), la correction de la quantité d'état ;
l'évaluation de la dégradation de la batterie sur la base de la quantité d'état corrigée ; et
dans un cas où la quantité d'état n'est pas en corrélation avec la quantité physique, l'évaluation de la dégradation de la batterie (20) sur la base de la quantité d'état acquise par l'acquisition (22, 30).

13. Programme selon la revendication 12, dans lequel la correction comprend en outre la correction de la quantité d'état avec une quantité de correction qui diffère selon un temps d'utilisation de la batterie (20).

14. Programme selon la revendication 12 ou la revendication 13, dans lequel la correction comprend en outre la correction de la quantité d'état avec une quantité de correction pré-spécifiée selon une amplitude de la quantité d'état.
